# EUROPEAN PATENT APPLICATION

(11) **EP 4 180 839 A1**
(43) Date of publication of application: **17.05.2023**
(21) Application number: 21836983.3
(22) Date of filing: 01.07.2021
(51) Int. Cl.: G01S 7/4863, G01S 17/894, H01L 27/146, H04N 5/376

(54) **TOF SENSOR**

(30) Priority: 10.07.2020 JP 2020119201
(71) Applicant: Gpixel Japan Co., Ltd., Tokyo 135-0064 (JP); Gpixel NV, 2018 Antwerpen (BE)
(72) Inventor: BOGAERTS Jan, 2018 Antwerpen (BE); HARADA Shingo, Tokyo 135-0064 (JP)
(74) Representative: TBK
(86) International application number: PCT/JP2021/024979
(87) International publication number: WO 2022/009775

(57) **Abstract**

[PROBLEM] To provide a TOF sensor equipped with a wiring structure that makes it possible to reduce pixel-by-pixel variation in the propagation delay time of a high-speed clock signal connected to the transfer gate of each pixel.

[Solution] This TOF sensor 200 comprises a pixel area 30 and a clock buffer area 20 arranged on one end side of the pixel area in the Y-direction thereof. Single pixels 40 or unit pixel groups 36 configured from a plurality of pixels are arranged in a two-dimensional matrix in the pixel area 30, a plurality of clocks for driving transfer gates 42 are each binarily split in the X-direction in the clock buffer area 20 and input to a final stage clock buffer 22 for driving unit pixel group rows 35 in which the unit pixel groups 36 are arranged in the Y-direction, and the output of the clock buffer 22 is binarily split in the Y-direction and connected to the transfer gates 42 of the unit pixel group rows 35.

## Description

### Technical Field

The present invention relates to a TOF (Time of Flight) sensor and, in particular, to an indirect TOF sensor that includes clock wiring that propagates high-speed clock signals for transfer gates.

### Background Art

For example, Patent Literature 1 (Japanese Patent Laid-Open No. 2000-340778) discloses an image sensor device having a small wiring delay variation width. The image sensor device in Patent Literature 1 includes a printed board having a shape that is long in a main scanning direction, and an image sensor chip. The image sensor chip includes: a shift register that includes n-stage flip-flop; a photoelectric conversion element array that includes n photoelectric conversion elements; a pixel switch array that includes n transistors; clock wiring that extends in the main scanning direction and is connected to a clock input terminal; and reading wiring that extends in the main scanning direction and is connected to an image signal output terminal. Wiring delays respectively occurring in time periods are substantially the same, by arranging the clock input terminal or the image signal output terminal either at one end or the other end between both the ends in the main scanning direction.

Patent Literature 2 (Japanese Patent Laid-Open No. 1996-129571) discloses a clock wiring layout in which the rise and fall times at the terminal end are uniform and which has a small skew. Patent Literature 2 proposes, as a conventional technology, an H-tree method that repeatedly branches clock wiring 4 in an H-shape, and designs the clock wiring so as to form a tree shape as a whole. The H-tree method regularly distributes a clock signal in a two-, four-, eight-fold... manner. Accordingly, the symmetry is high, and the load capacities (the wiring capacity, the input capacity of the gate on the next stage, etc.) of buffer amplifiers at each branch point are substantially identical, thus exerting an advantage of allowing the skew to be reduced.

Patent Literature 3 (Japanese Patent Laid-Open No. 1998-199985) also discloses a semiconductor integrated circuit that reduces unnecessary power consumption, and reduces the clock skew. Patent Literature 3 also describes, as a conventional technology, a chip layout that uses wiring 4 having an H-tree structure as clock wiring, in Figure 5(c). The technology shown in Figure 5(c) forms a wiring pattern having a predetermined shape on a chip, and arranges many flip-flops (not shown) supplied with the clock in accordance with the wiring pattern.

### Citation List

### Patent Literature

Patent Literature 1: Japanese Patent Laid-Open No. 2000-340778
Patent Literature 2: Japanese Patent Laid-Open No. 1996-129571
Patent Literature 3: Japanese Patent Laid-Open No. 1998-199985

### Summary of Invention

### Technical Problem

The TOF sensor adopts a method that measures a time from reflection of light emitted from a light source by an object to returning to the sensor, and calculates the distance based on the known speed of light. The distance measurement by the TOF method is originally point measurement where a photodiode, a short-pulse laser and a time measurement circuit are discretely configured. However, in recent years, accompanied by development of CMOS image sensors, an image sensor (time-resolved image sensor) capable of time measurement has been developed.

The TOF sensor includes a laser emission device and a reception device, measures a time difference from emission of a laser from the laser emission device to reception of the laser reflected on the surface of an object by the reception device, thus measuring the distance between the sensor and the object. Note that in the following description, the reception device is called a TOF sensor.

To measure the time difference, the TOF sensor generates, in the sensor, high-speed clock signals having multiple phases for transfer gates, transfers and accumulates charges caused in photodiodes in pixels multiple times in each time period where the transfer gate is on, outputs the amount of charges accumulated in the output circuit, and calculates the ratio of the accumulated amount of charges in each phase, thereby calculating a laser reception time in the reception device.

The TOF sensor transfers and accumulates charges caused in the photodiodes multiple times, and then reads out the charges. Accordingly, the operation of the output circuit is not required to be so fast. Meanwhile, to increase the temporal resolution of the TOF sensor, the pulse widths and the periods of the high-speed clock signals having multiple phases for the transfer gates are required to be reduced.

However, when the propagation delay times of the clock signals for the transfer gates for the pixels in the TOF sensor vary in the TOF sensor, the timings when the transfer gates are turned on vary, which results in a variation in measurement time among the pixels of the TOF sensor. Consequently, in order to reduce the variation in measurement time among the pixels of the TOF sensor, the propagation delay times of the clock signals for the transfer gates are required to be substantially the same.

In order to improve the spatial resolution of the TOF sensor, the number of pixels arranged as a two-dimensional array is required to be increased.

Consequently, an object that the present invention intends to achieve is to reduce the variation in propagation delay times of high-speed clock signals for transfer gates having small pulse widths and periods, among pixels, in a two-dimensional array TOF sensor having a large number of pixels.

The effort to reduce the variation in propagation delay times among the pixels is taken also in view of the system. Specifically, the variation in measurement time due to the variation in propagation delay time is measured and recorded before shipment. When the TOF sensor is actually used, the recorded variation in measurement time is read, and can be used to correct distance information when the distance is measured. However, the variation in propagation delay time changes due to variation in an environment where the TOF sensor is installed, for example, a variation in temperature. Consequently, when the variation in measurement time for correction is large, the variation in measurement time for correction also largely changes owing to variation in environment. As a result, the variation in the measured value of the distance after correction is large accordingly.

To facilitate the effort in view of the system, it is desirable that the variation in propagation delay time among pixels be not random and have a simplified tendency. Specifically, for example, the two-dimensionally arranged pixels that have a small variation in propagation delay time in the X direction and indicate a systematic variation also in the Y direction allow recording and correction with a small number of parameters.

In the image sensor device of the invention described in Patent Literature 1, the clock is turned on, and charges generated in the photoelectric conversion element are output as they are through the image signal output terminal. The photoelectric conversion element close to the clock input terminal has a small wiring delay in the clock wiring and the timing when the clock is turned on is fast but the wiring delay of charges caused in the photoelectric conversion element to the image signal output terminal is large. Conversely, the photoelectric conversion element on the opposite side of the clock input terminal has a large wiring delay in the clock wiring and the timing when the clock is turned on is slow but the wiring delay of charges caused in the photoelectric conversion element to the image signal output terminal is small. Consequently, the difference of delays due to the positions where the photoelectric conversion elements are arranged is small.

The method is effective in a case where the clock for causing charges and the clock for transferring the charges are the same, such as a case of a typical image sensor, but is not applicable to a case where charges caused at multiple clocks are accumulated and then transferred, such as a case of a TOF sensor. Consequently, the case of the TOF sensor requires to reduce the variation in propagation delay times of high-speed clock signals itself.

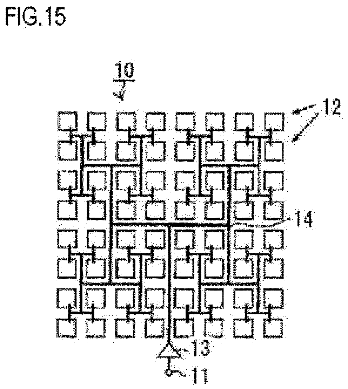

An example of wiring having an H-tree structure described in Patent Literatures 2 and 3 is shown in Figure 15. Figure 15 is a plan view illustrating an example of a clock wiring layout according to the H-tree method. In the diagram, reference numeral 10 denotes a semiconductor chip, reference numeral 11 denotes a clock input terminal, reference numeral 12 denotes terminal circuits (latch circuits), reference numeral 13 denotes a root buffer, and reference numeral 14 denotes clock wiring. The wiring of the H-tree structure in Figure 15 regularly branches a clock signal in a two-, four-, eight-fold... manner. Accordingly, the symmetry is high, and the load capacity (the wiring capacity, the input capacity of the gate on the next stage, etc.) of the buffer amplifier at each branch point is substantially identical, thus exerting an advantage of allowing the skew to be reduced.

However, in a case where an H-tree structure is applied to a two-dimensional array of TOF pixels, wiring is dense around the center of the array, and the closer to the periphery, the sparser the wiring is. Accordingly, there is a problem that it is difficult to maintain the uniformity among pixels, which is important for the two-dimensional array of TOF pixels.

In addition, the two-dimensional array of TOF pixels allows no clock buffer to be arranged in the array. Accordingly, the entire wiring having the H-tree structure is required to be driven by one clock buffer. Thus, there is another problem that it is difficult to design the clock buffer.

Furthermore, in a typical digital circuit, the circuit operates on a temporal axis where "one clock period" basically serves as a reference. Accordingly, only if the propagation delay time is, for example, in a range of half a clock frequency or less, a possible variation cases no problem. However, in the case of the TOF sensor, a temporal resolution of about 67 ps is required in order to achieve a distance resolution of 1 cm. Accordingly, for the TOF sensor, an effort in the system level is taken where the variation in measurement time due to the variation in propagation delay time is measured and recorded before shipment. At the time of actual use, the recorded variation in measurement time is read, and can be used to correct distance information when the distance is measured.

However, in the case of applying the H-tree structure to the clock wiring of the transfer gate, the variation in propagation delay time forms a two-dimensional distribution. Accordingly, there is a problem that simplification of a correction process, such as of independent correction of the Y direction, cannot be facilitated, for example.

A main object of the present invention is to provide a TOF sensor that includes pixels arranged two-dimensionally in the X direction and the Y direction, and can reduce the variation in the propagation delay times of high-speed clock signals connected to the transfer gates of the individual pixels.

A second object of the present invention is to provide a TOF sensor that has a small variation in propagation delay times among pixels in the X direction, and can significantly improve the measurement accuracy by correction only in the Y direction when a correction in a system level is performed.
(1) A TOF sensor according to one aspect includes: a pixel area that includes pixels arranged in an X direction and a Y direction; and a clock buffer area arranged on one end side of the pixel area in the Y direction, wherein unit pixel groups are two-dimensionally arranged in the pixel area, each of the unit pixel groups includes a single pixel, or a plurality of the pixels adjacent to each other in the X direction and/or the Y direction, each of the pixels of the unit pixel group includes a photodiode, a plurality of transfer gates, and a charge accumulation and output circuit, a plurality of clock signals for driving the corresponding transfer gates are each binary-branched in the X direction in the clock buffer area, and input into a clock buffer that drives a unit pixel group array where the unit pixel groups are arranged in the Y direction, and each piece of output wiring of the clock buffer that drives the unit pixel group array is binary-branched in the Y direction, and connected to the plurality of transfer gates of the unit pixel group array.

Note that binary-branching means N-time branching by repeating branching so as to first bifurcate the clock wiring and further bifurcate each of the two bifurcated pieces of clock wiring, thus achieving 2^{N} pieces of branched wiring.

The clock buffer is a circuit that amplifies the clock signal to drive a larger load, and includes two stages of inverters, for example.

In the TOF sensor according to the one aspect, it is defined so that the clock buffer area is arranged on the one end side in the Y direction, each piece of the output wiring of the clock buffer drives the corresponding unit pixel group array arranged in the Y direction. Alternatively, the internal arrangement of the TOF sensor may be rotated by 90 degrees, thus arranging the clock buffer area on one end side in the X direction.

In this case, the following advantageous effects are exerted.
(a) By driving the transfer gates of the unit pixel group array of the Y direction with the clock wiring binary-branched in the Y direction, the variation in propagation delay time in the unit pixel group array of the Y direction can be reduced in comparison with a case of driving the entire unit pixel group array of the Y direction with a single piece of clock wiring from one end.
(b) By binary-dividing the clock signal in the X direction in the clock buffer area, the variation in propagation delay times between the clock buffers that drive the respective unit pixel group arrays in the Y direction can be reduced.
(c) By the advantageous effect (b) described above, the variation between pixels in the X direction can be significantly reduced among the errors of the measurement distance between two-dimensionally arranged pixels. In a case of error correction in the system level, the measurement accuracy between two-dimensionally arranged pixels can be significantly improved only by error correction between pixels in the Y direction.

(2) A TOF sensor according to a second invention is the TOF sensor according to the one aspect, in which the clock buffer may be arranged at each of binary branch points of the respective clock signals binary-branched in the X direction, and the output of the clock buffer may be branched in two directions.

In this case, by appropriately configuring the size of the clock buffer arranged at each branch point, the absolute value and variation of the delay of the clock waveform, and rise and fall times can be reduced.

(3) A TOF sensor according to a third invention is the TOF sensor according to the one aspect and the second invention, in which each piece of the output wiring of the clock buffer on the last stage may be wired to a first branch point positioned at a midpoint of the pixel area in the Y direction, then bifurcated, and connected, in the unit pixel group array, to the transfer gates of the unit pixel groups on one end side of the first branch point and to the transfer gates of the unit pixel groups on the other end side of the the first branch point.

In this case, by driving from the midpoint of the pixel area in the Y direction, the variation in propagation delay times between the unit pixel groups in the Y direction reduces in comparison with a case of driving the entire array of pixels in the Y direction from the end with one piece of clock wiring.

(4) A TOF sensor according to a fourth invention is the TOF sensor according to the third invention, in which one piece of wiring bifurcated at the first branch point may be wired to a second branch point positioned at a quarter distance of the pixel area from one end in the Y direction, then bifurcated, and connected, in the unit pixel group array of the Y direction, to the transfer gates of the unit pixel groups on the one end side of the second branch point and to the transfer gates of the unit pixel groups between the second branch point and the first branch point, and
the other piece of wiring bifurcated at the first branch point is wired to a third branch point positioned at a three-quarter distance of the pixel area from the one end in the Y direction, then bifurcated, and connected, in the unit pixel group array of the Y direction, to the transfer gates of the unit pixel groups between the first branch point and the third branch point and to the transfer gates of the unit pixel groups on the other end side of the third branch point.

In this case, by driving the transfer gates of the pixels from the second branch point at the quarter of the array of the unit pixel group from the one end in the Y direction, and the third branch point at the three quarters of the array of the unit pixel group from the one end in the Y direction, the variation in propagation delay times between the pixels in the Y direction can be further reduced, in comparison with a case of driving the entire array of pixels in the Y direction from the end with one piece of clock wiring.

(5) A TOF sensor according to a fifth invention is the TOF sensor according to the fourth invention, in which the transfer gates of the two unit pixel groups adjacent to each other with respect to the first branch point in the Y direction may be connected to each other.

In this case, the variation in the propagation delay times of the transfer gates between two pixels adjacent to each other at the center of the pixel array in the Y direction due to the relative variation in wiring resistance, wiring capacitance or the like in the TOF sensor can be reduced.

(6) A TOF sensor according to a sixth invention is the TOF sensor according to the third to fifth inventions, in which wiring may be formed at a position symmetrical, with respect to the first branch point, to the wiring from an output of the clock buffer to the first branch point.

It is important for an image sensor to maintain uniformity about wiring and the like around each pixel as much as possible. This is because possible incapability of maintaining the uniformity causes a variation in a state, such as the parasitic capacitance between pixels, which in turn causes variations in the charge accumulation capability and the transfer capability. These directly result in a variation in distance measurement accuracy. Accordingly, the uniformity of the physical state, such as the parasitic capacitance between pixels, is required to be maintained as much as possible.

In the TOF sensors according to the third to fifth inventions, wiring that connects the clock buffer area arranged on the one end side in the Y direction to the first branch point, exists. In this case, by forming wiring at the position symmetric to the wiring from the clock buffer to the first branch point, the uniformity of wiring around each pixel can be maintained.

Note that, in one case, the formed wiring is dummy wiring that is independent from the clock wiring from the one end in the Y direction to the first branch point and extends from around the first branch point to the other end in the Y direction and, in another case, the clock wiring from the one end in the Y direction to the first branch point further extends to the other end in the Y direction.

The case of extending the clock wiring to the other end in the Y direction is advantageous in that the parasitic capacitance component between the wiring formed from the one end in the Y direction to the first branch point and from the first branch point to the other end in the Y direction and the branched clock wiring, and the dynamic operation situations can be aligned as much as possible, but is disadvantageous in that the parasitic capacitance component of the clock wiring increases.

(7) A TOF sensor according to a seventh invention is the TOF sensor according to the third to sixth inventions, in which an upper wiring layer is used for the wiring from an output of the clock buffer to the first branch point, and a lower wiring layer is used for the wiring from the first branch point to the transfer gate of each pixel.

The parasitic resistance and the parasitic capacitance of the wiring from the output of the clock buffer to the first branch point causes increase in the absolute value of the delay of the clock waveform, and the rise and fall times. In the TOF sensor according to the fourth invention, an upper wiring layer having a small sheet resistance and a small parasitic capacitance is used for the wiring from the output of the clock buffer to the first branch point, which can prevent the absolute value of the delay of the clock waveform, and the rise and fall times from increasing.

(8) A TOF sensor according to an eighth invention is the TOF sensor according to the one aspect to the seventh invention, in which the transfer gates of the unit pixel groups adjacent to each other in the X direction may further be connected to each other.

In this case, the variation in the propagation delay times at the transfer gates between the unit pixel group arrays adjacent to each other in the X direction due to the variation in the capacity of driving the clock buffer on the last stage and to the relative variation in the parasitic resistance and the parasitic capacitance of the wiring in the TOF sensor can be reduced.

Note that the clock wiring structure of the TOF sensor according to the present invention specifically suitable for a back irradiation sensor that can ignore the effects on exposure due to the wiring, and also applicable to a surface irradiation sensor with a certain pixel size, a certain number of wiring layers and the like.

### Brief Description of Drawings

[Figure 1] Figure 1 is a schematic plan view of a TOF sensor.
[Figure 2] Figure 2 is a schematic circuit view of a clock buffer area of the TOF sensor.
[Figure 3] Figure 3 is a schematic circuit diagram of an example of a pixel of the TOF sensor.
[Figure 4] Figure 4 is a schematic timing chart showing an example of an operation of the pixel of the TOF sensor.
[Figure 5] Figure 5 is a schematic diagram showing an example of a clock wiring layout of the TOF sensor.
Figure 5(a) corresponds to a case where clock wiring extends to the other end in the Y direction. Figure 5(b) corresponds to a case where independent dummy wiring extends to the other end in the Y direction.
[Figure 6] Figure 6 is a schematic diagram showing another example of a clock wiring layout of the TOF sensor. Figure 6(a) corresponds to a case where clock wiring extends to the other end in the Y direction.
Figure 6(b) corresponds to a case where independent dummy wiring extends to the other end in the Y direction.
[Figure 7] Figure 7 is a schematic diagram showing another example of a clock wiring layout of the TOF sensor, and corresponds to a case where independent dummy wiring extends to the other end in the Y direction.
[Figure 8] Figure 8 is a schematic circuit diagram showing an example of clock wiring of the TOF sensor.
[Figure 9] Figure 9 is a schematic circuit diagram showing another example of clock wiring of the TOF sensor.
[Figure 10] Figure 10 is a simulation circuit diagram of the TOF sensor with end-driven clock wiring.
[Figure 11] Figure 11 is a simulation circuit diagram of the TOF sensor with centrally driven clock wiring.
[Figure 12] Figure 12 is a simulation circuit diagram of the TOF sensor with clock wiring driven in 4 segments.
[Figure 13] Figure 13 is a comparison graph of absolute values of delay time at C terminals.
[Figure 14] Figure 14 is a comparison graph of relative values of delay time at C terminals.
[Figure 15] Figure 15 shows a wiring layout of an H-tree structure according to a conventional technology.

Hereinafter, referring to the drawings, an embodiment of the present invention is described. In the following description, the same components are assigned the same symbols. In a case of the same symbol, the name and the function of the components are also the same. Consequently, the detailed description thereof is not repeated.

### [Embodiment]

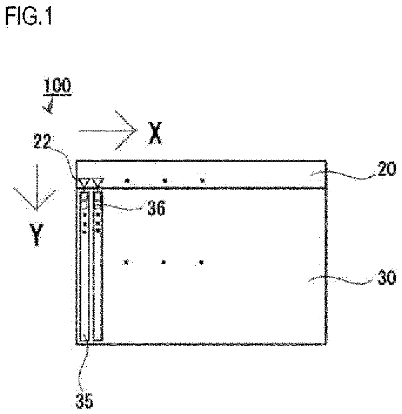

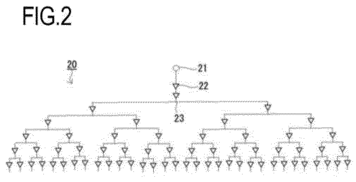

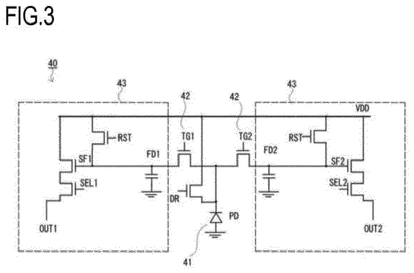

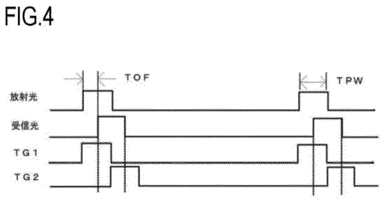

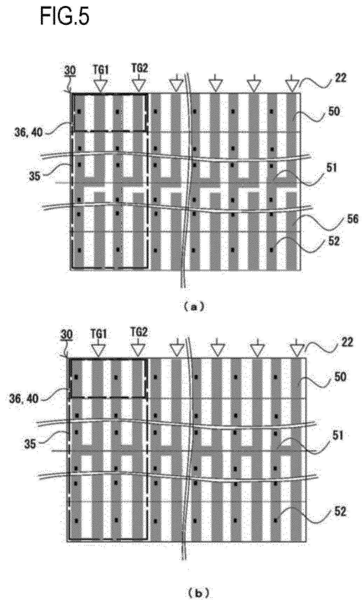

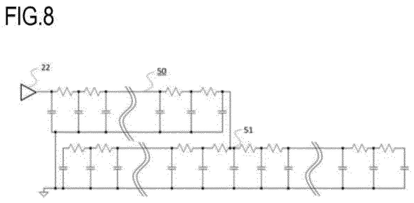

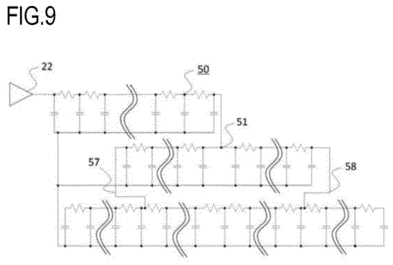

Figure 1 is a schematic plan view of a TOF sensor 100. Figure 2 is a schematic circuit diagram of a clock buffer area 20 of the TOF sensor 100. Figure 3 is a schematic circuit diagram of an example of a pixel 40 of the TOF sensor 100. Figure 4 is a schematic timing chart showing an example of an operation of the TOF sensor 100. Figures 5, 6 and 7 are schematic diagrams showing an example, another example and still another example of a layout of clock wiring 50 of the TOF sensor 100, respectively. Furthermore, Figures 8 and 9 are schematic circuit diagrams showing an example and another example of the clock wiring 50 of the TOF sensor 100, respectively.

### (Arrangement of entire TOF sensor 100)

As shown in Figure 1, in the TOF sensor 100, unit pixel groups 36 are arranged in the Y direction and form a unit pixel group array 35 of the Y direction, and furthermore, the unit pixel group arrays 35 in the Y direction are arranged in the X direction and form a two-dimensionally arranged pixel area 30, wherein unit pixel groups 36 each includes a single pixel 40 or a plurality of pixels 40 adjacent to each other in an X direction and/or a Y direction.

A clock buffer area 20 is formed on one end side of the pixel area 30 in the Y direction. Clock wiring 50 (not shown) for a high-speed clock signal that drives transfer gates 42 (not shown) of pixels 40 extends from the clock buffer area 20 to each unit pixel group array 35 of the Y direction.

Note that Figure 1 depicts one clock buffer 22 for each unit pixel group array 35 of the Y direction. However, each pixel 40 of the TOF includes a plurality of transfer gates 42. Although not shown in Figure 1, in conformity with the number of transfer gates 42 of the pixel 40 of the TOF, a plurality of clock buffers 22 are arranged for each unit pixel group array 35 of the Y direction.

Although not shown in Figure 1, the TOF sensor 100 includes a selection signal for selecting a pixel 40 from the unit pixel group array 35 of the Y direction and outputting, and a reading circuit for reading charges output from the unit pixel group array 35 of the Y direction.

### (Configuration and operation of clock buffer area 20)

As shown in Figure 2, a clock signal input from a clock input terminal 21 is amplified by the clock buffer 22 and then bifurcated, and each bifurcated clock signal is amplified by the clock buffer 22 and then is further bifurcated. By repeating the binary-branching, the clock signal is branched to become signals the number of which is the same as the number of unit pixel group arrays 35 of the Y direction.

In Figure 2, by five stages of branching, 32 clock outputs are formed. Typically, by N stages of branching, 2^{N} outputs can be obtained. Note that the number of the unit pixel group arrays 35 of the Y direction varies depending on the structure of the TOF sensor 100 or the required resolution in the X direction.

Figure 2 shows only one clock signal. However, in actuality, binary-branch circuits the number of which is the same as the number of transfer gates 42 of the pixels 40 are included in the clock buffer area 20.

In Figure 2, all the branching stages are provided with the respective clock buffers 22. Alternatively, some stages of branching may be provided with no clock buffer 22, and may be accompanied only by branching of wire.

In the clock buffers configured by binary branching in Figure 2, in a case where the output of the clock buffer 22 on the last stage corresponding to the output of the clock buffer area 20 is connected with the clock wiring 50 of the unit pixel group array 35 of the Y direction that has the same resistance and capacitance, the propagation delay times, rise and fall times and the like of the clock signals in the respective pieces of clock wiring 50 of the unit pixel group arrays 35 can be configured to be substantially the same.

### (Example of configuration and operation of pixel 40)

The present invention has an object to provide the TOF sensor 100 that includes a wiring structure capable of reducing the variation in the propagation delay times of high-speed clock signals connected to the transfer gates 42 among the pixels 40. Accordingly, the present invention is applicable to every pixel 40 that includes a plurality of transfer gates 42. However, a pixel 40 including two transfer gates 42 is herein exemplified, and the configuration and operation thereof are described.

As shown in Figure 3, in the pixel 40 for TOF, to sample charges of a photodiode 41 (PD) with a plurality of time windows (clocks), a plurality of transfer gates 42 (TG1 and TG2) are arranged. Charges sampled by the transfer gates 42 (TG1 and TG2) are accumulated in floating diffusions (FD1 and FD2), respectively, and read from outputs (OUT1 and OUT2) via source followers (SF1 and SF2) and select transistors (SEL1 and SEL2).

Figure 4 is a timing chart showing a principle of time measurement using the TOF sensor 100. Laser light with a pulse width TPW is emitted from a laser emission device, reflected by an object, and input as reception light into the photodiode 41 of the pixel 40. Meanwhile, between two modulation gates of the pixel 40, TG1 is first turned on, and TG2 is turned on delayed from TG1 by the pulse width TPW of the laser light. The reception light enters the TOF sensor 100 with a delay of a time of flight (TOF) corresponding to a time obtained by dividing the sum of the distance between the laser emission device and the object and the distance between the object and the TOF sensor 100 by the light speed. Charges caused in a time in which a pulse of the reception light and TG1 overlap are accumulated in FD1. Charges caused in a time in which a pulse of the reception light and TG2 overlap are accumulated in FD2. The amount of charges accumulated in FD1 and the amount of charges accumulated in FD2 are output, and the ratio of the amounts are calculated, thus allowing the TOF to be obtained.

Note that if a timing when the emitted laser light is turned on and a timing when TG1 is turned on deviate from each other, a measurement error occurs. If it is known how long the timing when TG1 is turned on delays from the timing when the emitted laser light is turned on, the measurement error can be adjusted by system level correction.

The transfer gate 42 modulates the pulse of the reception light with TG1 and TG2. Accordingly, the gate is also called as a gate for modulation.

However, if the timing when the laser light is emitted and the timings of TG1 and TG2 deviate more than an assumed deviation, a measurement error occurs in the distance obtained by the TOF sensor 100 accordingly, and the error serves as the error of the distance from the object. In particular, if the on and off timings of TG1 and TG2 deviate between the pixels 40 of the TOF sensor 100, an error occurs in the two-dimensional distribution of the measurement result of the distance from the object. Consequently, it is significantly important for the TOF sensor 100 including the two-dimensionally arranged pixels 40 in the X direction and the Y direction to reduce the variation in the propagation delay times of the clock signals TG1 and TG2 of the transfer gate 42 in the X direction and the Y direction.

As for the X direction between them, by using the clock buffers 22 having binary-branching configuration in Figure 2, the propagation delay times, the rise and fall times and the like of the clock signals at the outputs of the clock buffers 22 in the clock buffer area 20 can be made substantially the same. Consequently, in order to reduce the variation in propagation delay time between the pixels 40 arranged in the X and Y directions of the TOF sensor 100, it is important to reduce the variation in propagation delay times of the pixels 40 in the unit pixel group array 35 of the Y direction.

Figure 5 is a schematic diagram showing an example of a clock wiring layout of the TOF sensor 100. The output of the clock buffer 22 (TG1, TG2) on the last stage in the clock buffer area 20 extends to a first branch point 51 positioned at the midpoint of the pixel area 30 in the Y direction without connecting to any pixel, and bifurcated at this point. One piece of the clock wiring 50 is connected to the transfer gates 42 (not shown) of pixels 40 residing from the center in the Y direction to one end adjacent to the clock buffer area 20. The other piece of the clock wiring 50 is connected to the transfer gates 42 of pixels 40 residing from the center in the Y direction to the other end in the Y direction. Figure 5 shows an example in a case where the number of transfer gates 42 is two. Accordingly, the two pieces of clock wiring 50 are laid out for each unit pixel group array 35.

In Figure 5, wiring is formed at a position symmetrical, with respect to the first branch point 51, to the clock wiring 50 from the clock buffer 22 to the first branch point 51. This is for maintaining the uniformity of the wiring pattern around each pixel. Figure 5(a) corresponds to a case where the clock wiring 50 extends to the other end in the Y direction. Figure 5(b) corresponds to a case where independent dummy wiring 56 extends to the other end of the Y direction.

The case of extending the clock wiring 50 to the other end in the Y direction is advantageous in that the parasitic capacitance component between the wiring formed from the one end in the Y direction to the first branch point 51 and the branched clock wiring 50 and the parasitic capacitance component between the wiring formed from the first branch point 51 to the other end in the Y direction and the branched clock wiring 50 can be equalized, and the dynamic operation situation can be aligned as much as possible, but is disadvantageous in that the parasitic capacitance component of the clock wiring 50 increases.

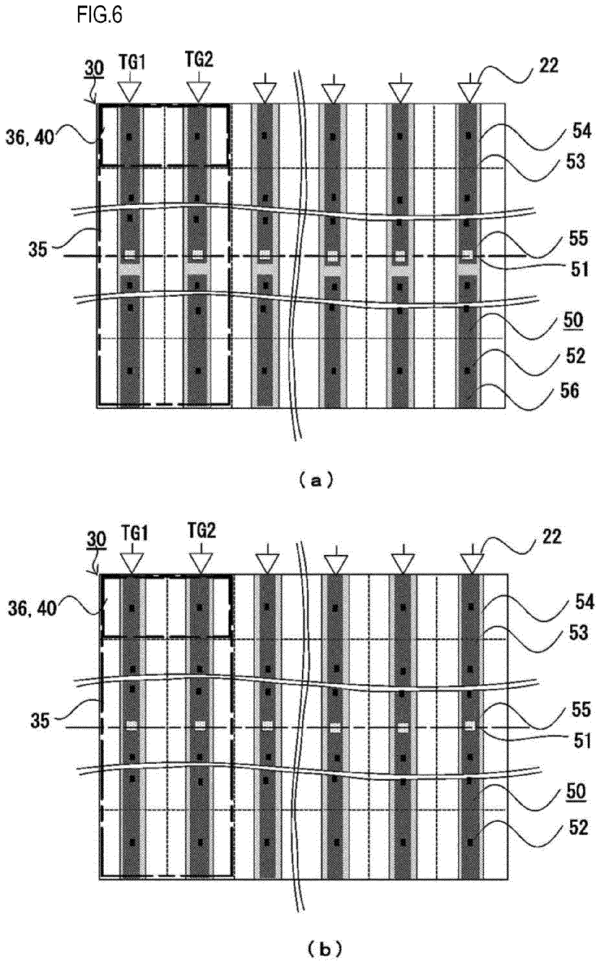

Figure 6 is a schematic diagram showing another example of a clock wiring layout of the TOF sensor 100. The clock wiring 50 includes an upper wiring layer 53 and a lower wiring layer 54 that are stacked with an insulation layer intervening between these layers. Figure 6 shows both the pieces of the clock wiring 50. The output of the clock buffer 22 on the last stage (TG1, TG2) in the clock buffer area 20 extends to the first branch point 51 positioned at the center of the unit pixel group array 35 of the Y direction by the upper wiring layer 53, and is connected thereat to the lower wiring layer 54 through a via 55 that connects the upper wiring layer 53 to the lower wiring layer 54. The lower wiring layer 54 is connected to the transfer gates 42 of the pixels 40 residing from the center in the Y direction to the one end adjacent to the clock buffer area 20, and to the transfer gates 42 of the pixels 40 residing from the center in the Y direction to the other end. Figure 6 also shows an example in a case where the number of transfer gates 42 is two. Accordingly, the two pieces of clock wiring 50 are laid out for each unit pixel group array 35.

Also in Figure 6, wiring is formed at a position symmetrical, with respect to the first branch point 51, to the clock wiring 50 from the clock buffer 22 to the first branch point 51. Figure 6(a) corresponds to a case where the clock wiring 50 extends to the other end in the Y direction. Figure 6(b) corresponds to a case where independent dummy wiring 56 extends to the other end in the Y direction.

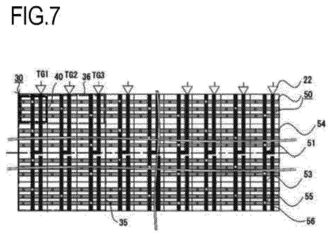

Figure 7 is a schematic diagram showing still another example of a clock wiring layout of the TOF sensor 100. In Figure 7, three pixels 40 adjacent in the X direction constitute a unit pixel group 36. In the example of Figure 7, the clock for driving the transfer gates 42 has three phases. The outputs of the three clock buffers 22 (TG1, TG2 and TG3) are not connected to any pixel 40, extend to the first branch point 51 positioned at the midpoint of the pixel area 30 in the Y direction, are bifurcated thereat, and are connected to the corresponding unit pixel groups 36. The output of the clock buffer 22 is wired using the upper wiring layer 53, is connected at each unit pixel group 36 to the lower wiring layer 54 through the via 55 that connects the upper wiring layer 53 to the lower wiring layer 54, and is connected to the transfer gates 42 of the pixels 40 by the lower wiring layer 54.

In the example of Figure 7, pieces of the lower wiring layer 54 corresponding to the unit pixel groups 36 adjacent in the X direction are connected to each other. The clock signal in the present invention is binary-branched in the X direction in the clock buffer area 20. The shapes of the pieces of clock wiring 50 and the transfer gates 42 of the unit pixel group array 35 of the Y direction are the same in the X direction. Accordingly, in theory, the waveforms of the unit pixel groups 36 adjacent in the X direction on the lower wiring layer 54 are the same. However by connecting the pieces of the lower wiring layer 54 of the unit pixel groups 36 adjacent in the X direction on the lower wiring layer 54 to each other, the variation in the propagation delay times of the transfer gates 42 between the unit pixel groups 36 adjacent in the X direction due to the variation in drive capability of the clock buffer 22 on the last stage and to the parasitic resistance and parasitic capacitance of the clock wiring 50, can be reduced.

Note that in the example of Figure 7, the three pixels 40 adjacent in the X direction constitute the unit pixel group 36. For example, two sets of three pixels 40 adjacent in the X direction may be further coupled to each other in the Y direction, thus constituting a unit pixel group 36 made up of total six pixels 40. The unit pixel group 36 may be made up only of pixels 40 adjacent in the Y direction.

Also in Figure 7, wiring is formed at a position symmetrical, with respect to the first branch point 51, to the clock wiring 50 from the clock buffer 22 to the first branch point 51. Figure 7 corresponds to a case where independent dummy wiring 56 extends to the other end in the Y direction.

Figure 8 is an equivalent circuit diagram of the clock wiring 50 corresponding to the layouts of Figures 5 to 7. The clock wiring 50 extends from the output of the clock buffer 22 to the first branch point 51, then bifurcated, and extends to the one end of the unit pixel group array 35 of the Y direction and to the other end. Figure 8 illustrates that the clock wiring 50 has a cascade connection of C-R-C in order to address the delay of the clock signal in the clock wiring 50.

According to the configuration of Figure 8, the output of the clock buffer 22 propagates from the first branch point 51 toward the one end and the other end. Accordingly, in comparison with a case of causing the output of the clock buffer 22 to propagate from the one end to the one end, the variation in the propagation delay time in the lower piece of clock wiring 50 in Figure 8 corresponding to the unit pixel group array 35 of the Y direction is small.

Figure 9 is a schematic circuit diagram showing another example of the clock wiring 50 of the TOF sensor 100. In Figure 9, the wiring extends from the output of the clock buffer 22 to the first branch point 51, is branched thereat, then one piece of the clock wiring 50 further extends from the one end of the pixel area 30 in the Y direction to a second branch point 57 positioned at a quarter distance, and is further bifurcated thereat, and one of the bifurcated pieces extends toward the one end of the unit pixel group array 35 of the Y direction and the other extends toward the first branch point 51. The other piece of clock wiring 50 branched at the first branch point 51 further extends from the one end of the pixel area 30 in the Y direction to a third branch point 58 positioned at a three-quarter distance, and is further bifurcated thereat, and one of the bifurcated pieces extends toward the other end of the unit pixel group array 35 of the Y direction and the other extends toward the first branch point 51.

According to the configuration of Figure 9, the propagation delay times from the output of the clock buffer 22 to the second branch point 57 and to the third branch point 58 are the same. Accordingly, the variation in propagation delay times is limited to the variation in a quarter section of the entire lower piece of clock wiring 50 in Figure 9 corresponding to the unit pixel group array 35 of the Y direction. Consequently, even in comparison with the case of Figure 8 where the output of the clock buffer 22 propagates from the first branch point 51 to the one end and to the other end, the variation in propagation delay times can be further reduced.

Note that in Figure 9, the modulation gates of the pixels of the unit pixel group array 35 of the Y direction are driven from the quarter and three-quarter points on the clock wiring 50 that connects the unit pixel group array 35 of the Y direction. Furthermore, it may be configured so that the wiring is further branched at the quarter and three-quarter points, and the transfer gates 42 of the pixels of the unit pixel group array 35 of the Y direction are driven from the 1/8, 3/8, 5/8 and 7/8 points.

In further general, by binary-branching, in the Y direction, the clock wiring 50 that connects the unit pixel group array 35 of the Y direction and then by connecting the wiring to the unit pixel group 36, the variation in the propagation delay times can be reduced. N-time binary-branching achieves 2^{N} binary-branched pieces of wiring. Accordingly, the transfer gates 42 of the unit pixel group 36 are allowed to be driven from 1/2 ^{N}, 3/2^{N},..., (2^{N}-1)/2^{N} points on the clock wiring 50 that connects the unit pixel group array 35 of the Y direction.

In Figure 9, the piece of clock wiring 50 extending from the second branch point 57 toward the first branch point 51 side and the piece of clock wiring 50 extending from the third branch point 58 toward the first branch point 51 side are connected to each other at the first branch point 51. The ends of the two pieces of clock wiring 50 theoretically have the same propagation delay time. Accordingly, the two pieces of clock wiring 50 may be connected or not necessarily be connected. However, for the variation in propagation delay times due to the relative variation in the resistance values or parasitic capacitance values of the two pieces of wiring, it is advantageous to connect the two pieces of clock wiring 50 to each other.

### (Verification of reduction in variation in propagation delay times by simulation using schematic circuit)

For a case of driving the clock wiring 50 connected to the unit pixel group array 35 of the Y direction from an end, a case of driving from the center as shown in Figure 8, and a case of driving from the quarter point and the three-quarter point as shown in Figure 9, a circuit simulation is performed assuming that the clock wiring 50 has a cascade connection of C-R-C, and the difference of the variations in propagation delay times is verified.

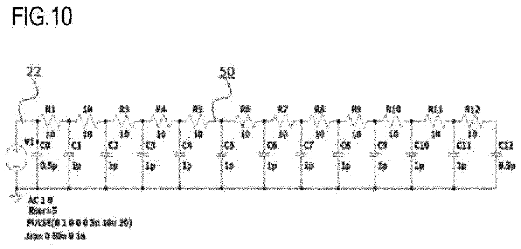

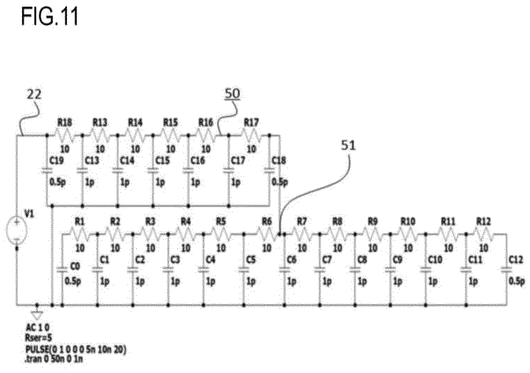

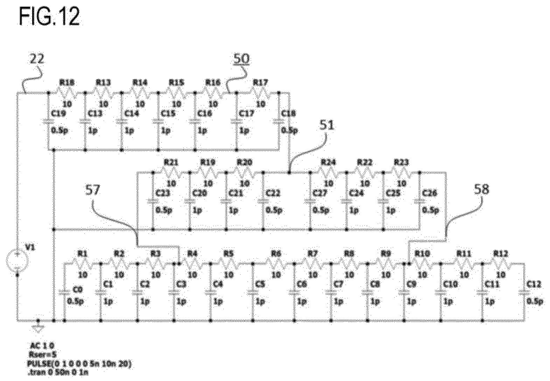

A diagram of a circuit used for a simulation in a case where the clock wiring 50 that connects the unit pixel group array 35 of the Y direction is driven from an end is shown in Figure 10. A diagram of a circuit used for a simulation in a case of driving from the center (first branch point 51) as in Figure 8 is shown in Figure 11. A diagram of a circuit used for a simulation in a case driving from the quarter point (second branch point 57) and the three-quarter point (third branch point 58) as in Figure 9 is shown in Figure 12. Figures 10 to 12 assume that the clock wiring 50 that connects the unit pixel group array 35 of the Y direction is divided into 12 pieces. Each of 12 divided pieces of clock wiring 50 has a resistance of 10 Ω, a parasitic capacitance of 0.5 pF + 0.5 pF, the clock buffer 22 has an output resistance of 5 Ω, and the clock frequency is 100 MHz. A time from the rise of the clock buffer 22 to reaching of the voltage at each of points C0 to C12 in the diagram to half the clock frequency is assumed as the propagation delay time.

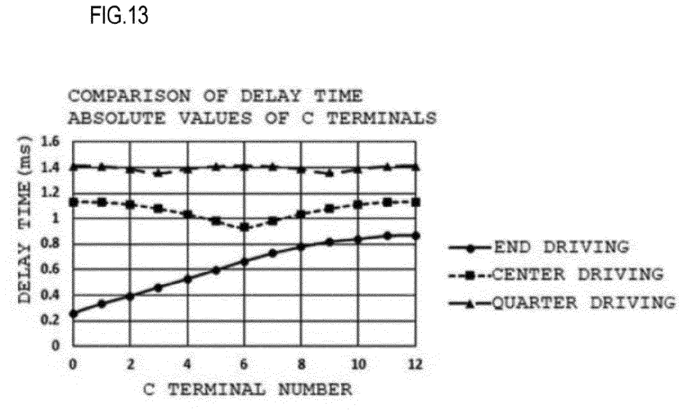

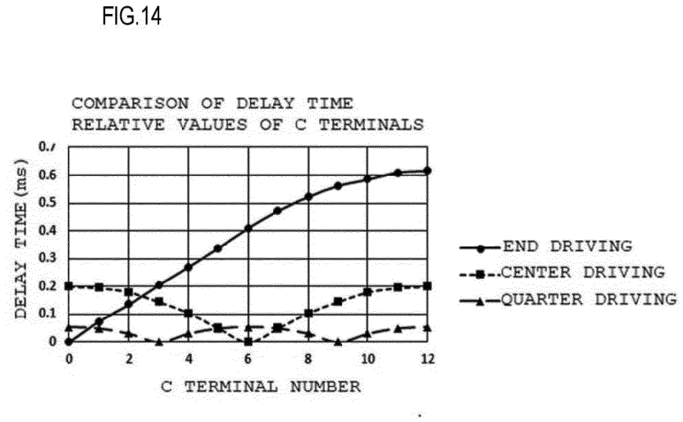

Figure 13 shows the absolute values of the propagation delay times at each C terminal in the circuits in Figures 10 to 12. Figure 14 shows the propagation delay times at each C terminal in cases where the point with the minimum propagation delay time is assumed as zero. The propagation delay times in Figure 14 correspond to the variations in propagation delay times in the clock wiring 50 that connects the unit pixel group array 35 of the Y direction.

In Figure 13, the absolute value of the propagation delay time at each C terminal is the minimum in the case of end driving in Figure 10, is intermediate in the case of center driving in Figure 11, and is the maximum in the case of quarter driving in Figure 12. This is because in the circuit of Figure 11, the delay of the wiring from the clock buffer 22 to the first branch point 51 is added, and in the circuit of Figure 12, the delays of wiring from the clock buffer 22 to the second branch point 57 and the third branch point 58 are added.

On the other hand, referring to Figure 14, the variation in propagation delay times in the clock wiring 50 that connects the unit pixel group array 35 of the Y direction in the case of center driving in Figure 11 is about 1/3 of that in the case of the end driving in Figure 10. Furthermore, the variation in the case of quarter driving in Figure 12 is about 1/3 of that in the case of center driving, and is about 1/10 of that in the case of end driving.

Consequently, in the TOF sensor 100 that includes the pixels 40 two-dimensionally arranged in the X direction and the Y direction, the variation among pixels 40 in propagation delay times of high-speed clock signals connected to the transfer gates 42 of the pixels 40 can be reduced to about 1/3 of that in the case of end driving by the following wiring method.
The following wiring method means that the clock wiring 50, which is the output of the clock buffer 22, is wired to the first branch point 51 corresponding to the center of the unit pixel group array 35 of the Y direction, then bifurcated, one piece of clock wiring 50 is connected from the first branch point 51 to the transfer gates 42 of the pixels 40 residing from the first branch point 51 to the one end, and the other piece of clock wiring 50 is connected to the transfer gates 42 of the pixels 40 residing from the first branch point 51 to the other end.

In the case where the wiring is connected from the first branch point 51 further to the quarter point (second branch point 57) of the unit pixel group array 35 of the Y direction and the three-quarter point (third branch point 58), and then connected from the branch points to the transfer gates 42 of the unit pixel group arrays 35 in the Y direction, the variation among pixels 40 in propagation delay times of high-speed clock signals connected to the transfer gates 42 of the pixels 40 can be reduced to about 1/10 of that in the case of end driving.

Note that the clock wiring structure of the TOF sensor 100 according to the present invention is specifically suitable for a back irradiation sensor that can ignore the effects on exposure due to the wiring, and also applicable to a surface irradiation sensor with a certain size of the pixel 40, a certain number of wiring layers and the like.

In the present invention, the pixel area 30 corresponds to "pixel area", the clock buffer area 20 corresponds to "clock buffer area", the TOF sensor 100 corresponds to "TOF sensor", the pixel 40 corresponds to "pixel", the photodiode 41 corresponds to "photodiode", the transfer gate 42 corresponds to "transfer gate", the charge accumulation and output circuit 43 corresponds to "charge accumulation and output circuit", the unit pixel group 36 corresponds to "unit pixel group", the unit pixel group array 35 corresponds to "unit pixel group array", the clock buffer 22 corresponds to "clock buffer", the first branch point 51 corresponds to "first branch point", the second branch point 57 corresponds to "second branch point", the third branch point 58 corresponds to "third branch point", the upper wiring layer 53 corresponds to "upper wiring layer", and the lower wiring layer 54 corresponds to "lower wiring layer".

The preferred embodiment of the present invention is as described above. However, the present invention is not limited only to this. It should be understood that various embodiments without departing from the spirit and scope of the present invention are implemented alternatively. Furthermore, in this embodiment, the operations and advantageous effects according to the configuration of the present invention are described. These operations and advantageous effects are only examples, and do not limit the present invention.

### Reference Signs List

- 10: Semiconductor chip

- 11: Clock input terminal
- 12: Terminal circuit (latch circuit)
- 13: Root buffer
- 14: Clock wiring
- 20: Clock buffer area
- 21: Clock input terminal
- 22: Clock buffer
- 30: Pixel area
- 35: Unit pixel group array
- 36: Unit pixel group
- 40: Pixel
- 41: Photodiode
- 42: Transfer gate
- 43: Charge accumulation and output circuit
- 50: Clock wiring
- 51: First branch point
- 53: Upper wiring layer
- 54: Lower wiring layer
- 55: Via connecting upper wiring layer to lower wiring layer
- 56: Dummy wiring
- 57: Second branch point
- 58: Third branch point
- 100: TOF sensor

### Figure 4

- #1: EMITTED LIGHT
- #2: RECEPTION LIGHT

### Figure 13

- #1: COMPARISON OF DELAY TIME ABSOLUTE VALUES OF C TERMINALS
- #2: DELAY TIME
- #3: END DRIVING
- #4: CENTER DRIVING
- #5: QUARTER DRIVING
- #6: C TERMINAL NUMBER

### Figure 14

- #1: COMPARISON OF DELAY TIME RELATIVE VALUES OF C TERMINALS
- #2: DELAY TIME
- #3: END DRIVING
- #4: CENTER DRIVING
- #5: QUARTER DRIVING
- #6: C TERMINAL NUMBER

## Claims

1. A TOF sensor comprising: a pixel area that includes pixels arranged in an X direction and a Y direction; and a clock buffer area arranged on one end side of the pixel area in the Y direction, wherein
unit pixel groups are two-dimensionally arranged in the pixel area, each of the unit pixel groups includes a single pixel, or a plurality of the pixels adjacent to each other in the X direction and/or the Y direction, each of the pixels of the unit pixel group includes a photodiode, a plurality of transfer gates, and a charge accumulation and output circuit,
a plurality of clock signals for driving the corresponding transfer gates are each binary-branched in the X direction in the clock buffer area, and input into a clock buffer that drives a unit pixel group array where the unit pixel groups are arranged in the Y direction, and
each piece of output wiring of the clock buffer that drives the unit pixel group array is binary-branched in the Y direction, and connected to the plurality of transfer gates of the unit pixel group array.

2. The TOF sensor according to claim 1, wherein the clock buffer is arranged at each of binary branch points of the respective clock signals binary-branched in the X direction, and an output of the clock buffer is branched in two directions.

3. The TOF sensor according to claim 1 or 2, wherein each piece of the output wiring of the clock buffer that drives the unit pixel group array is wired to a first branch point positioned at a midpoint of the pixel area in the Y direction, then bifurcated, and connected, in the unit pixel group array, to the transfer gates of the unit pixel groups on one end side of the first branch point and to the transfer gates of the unit pixel groups on the other end side of the first branch point.

4. The TOF sensor according to claim 3, wherein
one piece of wiring bifurcated at the first branch point is wired to a second branch point positioned at a quarter distance of the pixel area from one end in the Y direction, then bifurcated, and connected, in the unit pixel group array of the Y direction, to the transfer gates of the unit pixel groups on the one end side of the second branch point and to the transfer gates of the unit pixel groups between the second branch point and the first branch point, and
the other piece of wiring bifurcated at the first branch point is wired to a third branch point positioned at a three-quarter distance of the pixel area from the one end in the Y direction, then bifurcated, and connected, in the unit pixel group array of the Y direction, to the transfer gates of the unit pixel groups between the first branch point and the third branch point and to the transfer gates of the unit pixel groups on the other end side of the third branch point.

5. The TOF sensor according to claim 4, wherein the transfer gates of the two unit pixel groups adjacent to each other with respect to the first branch point in the Y direction are connected to each other.

6. The TOF sensor according to any one of claims 3 to 5, wherein wiring is formed at a position symmetrical, with respect to the first branch point, to the wiring from an output of the clock buffer to the first branch point.

7. The TOF sensor according to any one of claims 3 to 6, wherein an upper wiring layer is used for the wiring from an output of the clock buffer to the first branch point, and a lower wiring layer is used for the wiring from the first branch point to the transfer gate of each unit pixel group.

8. The TOF sensor according to any one of claims 1 to 7, wherein the transfer gates of the unit pixel groups adjacent to each other in the X direction are further connected to each other.
